# EUROPEAN PATENT SPECIFICATION

(11) **EP 3 364 140 B1**
(45) Date of publication and mention of the grant of the patent: **01.12.2021**
(21) Application number: 16855126.5
(22) Date of filing: 14.10.2016
(51) Int. Cl.: F28D 15/02, H05K 7/20, H01L 23/427

(54) **COOLING DEVICE**
KÜHLVORRICHTUNG
DISPOSITIF DE REFROIDISSEMENT

(30) Priority: 15.10.2015 JP 2015203568
(43) Date of publication of application: 22.08.2018
(73) Proprietor: NEC Platforms, Ltd., Kawasaki-shi, Kanagawa 213-8511 (JP)
(72) Inventor: NAKAMURA, Yasuhito, Kawasaki-shi Kanagawa 213-8511 (JP); FUJII, Shunsuke, Kawasaki-shi Kanagawa 213-8511 (JP)
(74) Representative: Betten & Resch
(86) International application number: PCT/JP2016/004593
(87) International publication number: WO 2017/064872

(56) References cited:
- EP-A1- 2 816 881
- WO-A1-2011/122207
- CN-A- 101 814 469
- JP-A- 2009 193 137
- JP-U- S5 714 453
- JP-U- S61 169 374
- US-A1- 2009 014 155
- US-A1- 2009 122 488
- US-A1- 2011 103 009
- US-A1- 2013 019 627

## Description

### [Technical Field]

The present invention relates to a cooling device and particularly relates to a cooling device that cools an electronic device using a phase change phenomenon of refrigerant.

### [Background Art]

In recent years, the amount of information has substantially increased due to expansion of Internet services and the like. For this reason, a data center dealing with information is required to install a lot of electronic devices, such as a server and a network device that perform information processing. Installation of a lot of electronic devices in this manner increases air conditioning power required for cooling such electronic devices.

Accordingly, as an example of a cooling method requiring low air conditioning power, technologies relating to a phase change cooling method in which a phase change phenomenon of refrigerantrefrigerant is used are known, and, for example, PTL 1 discloses a technology relating to an electronic device cooling system. The technology described in PTL 1 enables electronic devices in a casing to be cooled by connecting a rear door and a cooling bath by means of a flexible tube and, between the rear door and the cooling bath, making refrigerant undergo a phase change.

Since a substantial increase in the amount of information causes an increase in the amount of heat generated by the electronic devices, it is required to increase the diameter of the flexible tube, which serves as a flow path for refrigerant, according to the increase in the amount of heat. In addition, since an increase in the diameter of the flexible tube also causes an increase in the bending radius of the flexible tube, it is required to distance the cooling bath from the rear door. However, the above-described technology described in PTL 1 employs a configuration in which the cooling bath is disposed in a vicinity of the rear door, that is, a configuration that prevents the diameter of the flexible tube from being increased. Because of the configuration, there is a possibility that, when a lot of electronic devices are installed, the above-described technology described in PTL 1 cannot sufficiently dissipate heat generated by the electronic devices.

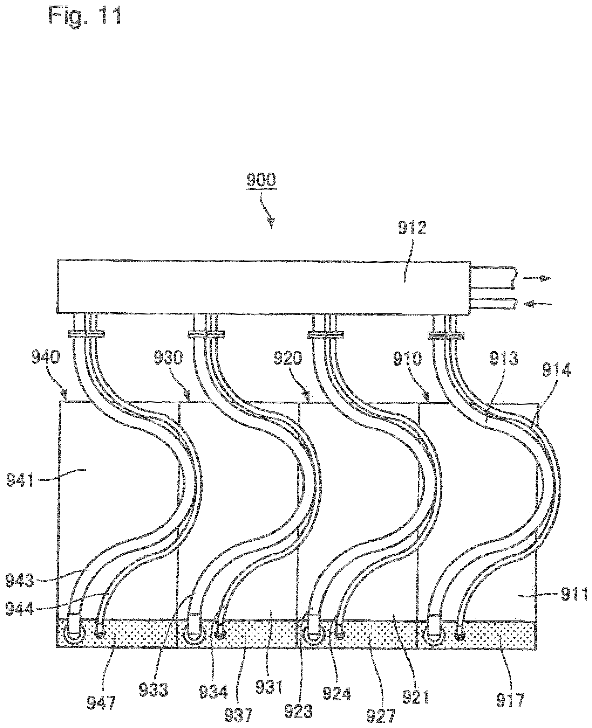

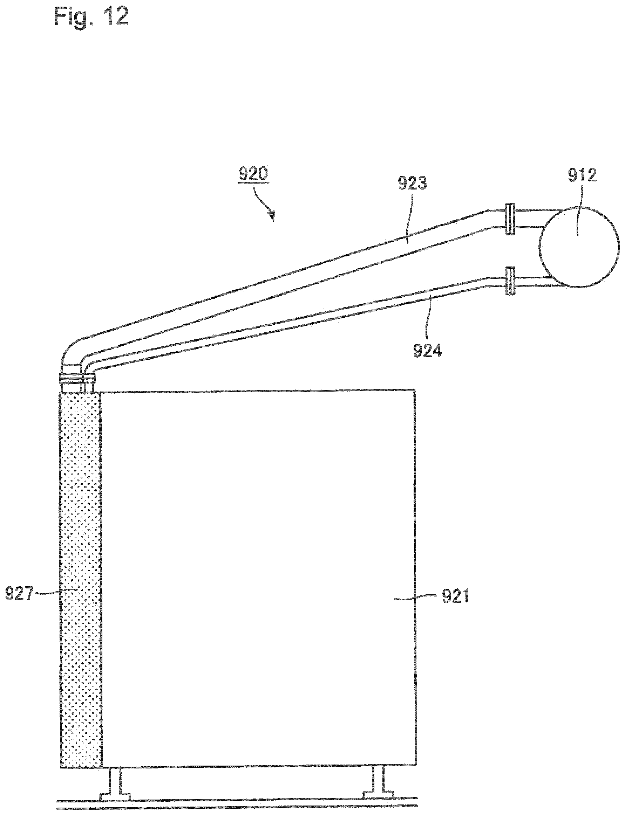

Accordingly, as a configuration that enables the diameter of a flexible tube to be increased, a cooling system 900, exemplified in Figs. 11 and 12, is known. Using Figs. 11 and 12, the related cooling system 900 will be described. Figs. 11 and 12 are a plan view and a side view of the related cooling system 900, respectively.

A cooling device 920 of the cooling system 900 includes an evaporating unit 927, a flexible tube 923, and a refrigerant relay 912. The refrigerant relay 912 is disposed at a position distanced from the evaporating unit 927. The refrigerant relay 912 and the evaporator 927 are connected to each other by means of the flexible tube 923, and the flexible tube 923 is made longer than the straight line distance between the refrigerant relay 912 and the evaporator 927, that is, is disposed provided with a surplus length. The configuration of the cooling device 920 enables opening and closing of the rear-surface door even when the diameter of the flexible tube 923 is increased.

Note that other technologies related to the present invention are also disclosed in PTLs 2 and 3. Documents EP 2 816 881 A1 (figs. 10, 11), US 2009/122488 A1 (figs. 6, 7) and US 2011/103009 (figs. 4, 5) disclose further cooling devices for electric devices.

### [Citation List]

### [Patent Literature]

[PTL 1] JP 2009-134531 A
[PTL 2] JP 2012-179728 A
[PTL 3] JP 2006-101817 A

### [Summary of Invention]

### [Technical Problem]

However, the above-described cooling device 920 having the refrigerant relay 912 and the evaporator 927 distanced from each other causes an increase in the space for installation. For this reason, while the cooling device 920 has no problem when there is enough space for installing a lot of casings in a data center, a lot of cooling devices 920 cannot be installed in the data center when enough space is not available. In addition, in the cooling device 920, disposition of the refrigerant relay 912 closer to the side on which the evaporator 927 is disposed causes the flexible tube 923 to extend out of the place for installation, which eventually increases the space for installation. This constraint requires the cooling device 900 to secure a distance equal to or longer than a predetermined distance between the casing 912 and other casings, which has caused an increase in the space for installation.

An object of the present invention is to provide a cooling device and a cooling system that are capable of suppressing an increase in space for installation.

### [Solution to Problem]

In order to achieve the above-described object, a cooling device according to the present invention is defined in claim 1.

In order to achieve the above-described object, the cooling device according to the present invention includes a plurality of the evaporators, wherein each of the plurality of the evaporators is connected to the refrigerant relay.

### [Advantageous Effects of Invention]

The present invention enables an increase in space for installation to be suppressed.

### [Brief Description of Drawings]

[Fig. 1] Fig. 1 is a plan view of a cooling system according to an example embodiment (first example embodiment) of the present invention;
[Fig. 2] Fig. 2 is a plan view of a cooling system according to another example embodiment (second example embodiment) of the present invention;
[Fig. 3] Fig. 3 is a side view of the cooling system according to the another example embodiment (second example embodiment) of the present invention;
[Fig. 4] Fig. 4 is a plan view of the cooling system according to the another example embodiment (second example embodiment) of the present invention and a diagram illustrating a state in which a rear-surface door of a casing is opened;
[Fig. 5] Fig. 5 is a side view of the cooling system according to the another example embodiment (second example embodiment) of the present invention and another diagram illustrating the state in which the rear-surface door of the casing is opened;
[Fig. 6] Fig. 6 is a plan view of a cooling system according to still another example embodiment (third example embodiment) of the present invention;
[Fig. 7] Fig. 7 is a side view of the cooling system according to the still another example embodiment (third example embodiment) of the present invention;
[Fig. 8] Fig. 8 is a rear view of the cooling system according to the still another example embodiment (third example embodiment) of the present invention;
[Fig. 9] Figs. 9 is a plan view of the cooling system according to the still another example embodiment (third example embodiment) of the present invention and a diagram illustrating a state in which a rear-surface door of a casing is opened;
[Fig. 10] Fig. 10 is a side view of the cooling system according to the still another example embodiment (third example embodiment) of the present invention and another diagram illustrating the state in which the rear-surface door of the casing is opened;
[Fig. 11] Fig. 11 is a plan view of a related cooling system; and
[Fig. 12] Fig. 12 is a side view of the related cooling system.

### [Description of Embodiments]

Hereinafter, example embodiments of the present invention will be described using the drawings.

### (First Example Embodiment)

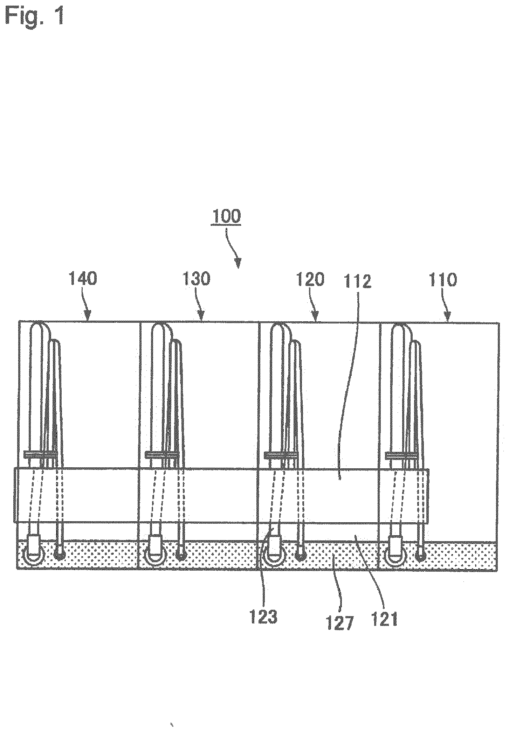

An example embodiment (first example embodiment) of the present invention will be described using Fig. 1. Fig. 1 is a plan view of a cooling system 100 according to the present example embodiment (first example embodiment). The cooling system 100 is configured including a plurality of cooling devices 110, 120, 130, and 140 and a refrigerant relay 112 that is connected to the respective ones of the plurality of cooling devices 110, 120, 130, and 140. Note that, since the plurality of cooling devices 110, 120, 130, and 140 have the same configuration, the cooling device 120 will be described and a description of the other cooling devices 110, 130, and 140 will be omitted.

The cooling device 120 is configured including an evaporator 127, the refrigerant relay 112, and a flexible tube 123. The evaporator 127 is disposed on a rear-surface door that is mounted on a casing 121 in an openable and closable manner. The refrigerant relay 112 is placed above the casing 121 and connected to a not-illustrated condenser. The flexible tube 123 has one end and the other end connected to the evaporator 127 and a side of the refrigerant relay 112 different from the side thereof on which the evaporator 127 is disposed, respectively. The flexible tube 123 is configured so as to be freely bendable. In addition, at least a portion of the flexible tube 123 is disposed below the refrigerant relay 112 so as to cross the refrigerant relay 112 in a grade-separated manner. In the above, the side of the refrigerant relay 112 on which the evaporator 127 is disposed and the side of the refrigerant relay 112 different therefrom correspond to the rear-surface side and the front-surface side of the casing 121, respectively. In other words, the other end of the flexible tube 123 is connected to the front-surface side of the refrigerant relay 112 with respect to the casing 121. In addition, the crossing in a grade-separated manner corresponds to, by making the flexible tube 123, after passing below the refrigerant relay 112 from the side on which the evaporator 127 is disposed, reverse the extending direction thereof and be connected to the refrigerant relay 112, making the refrigerant relay 112 and the flexible tube 123 cross each other above the casing 121.

As described above, the cooling device 120 has the refrigerant relay 112 placed above the casing 121 and the flexible tube 123 connected to the evaporator 127 and the side of the refrigerant relay 112 different from the side thereof on which the evaporator 127 is disposed. Making the refrigerant relay 112 and the flexible tube 123 cross each other in a grade-separated manner enables the cooling device 120 to keep the refrigerant relay 112 and the flexible tube 123 contained within an area above a space for installation of the casing 121. In consequence, an increase in space for installation may be suppressed in the present example embodiment.

### (Second Example Embodiment)

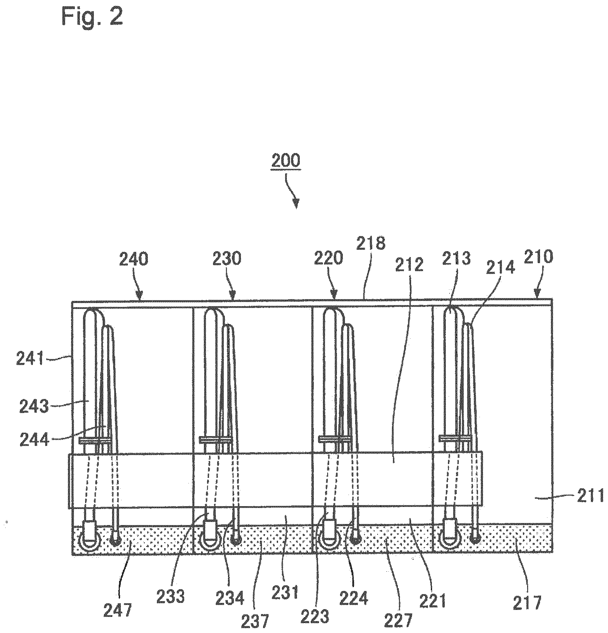

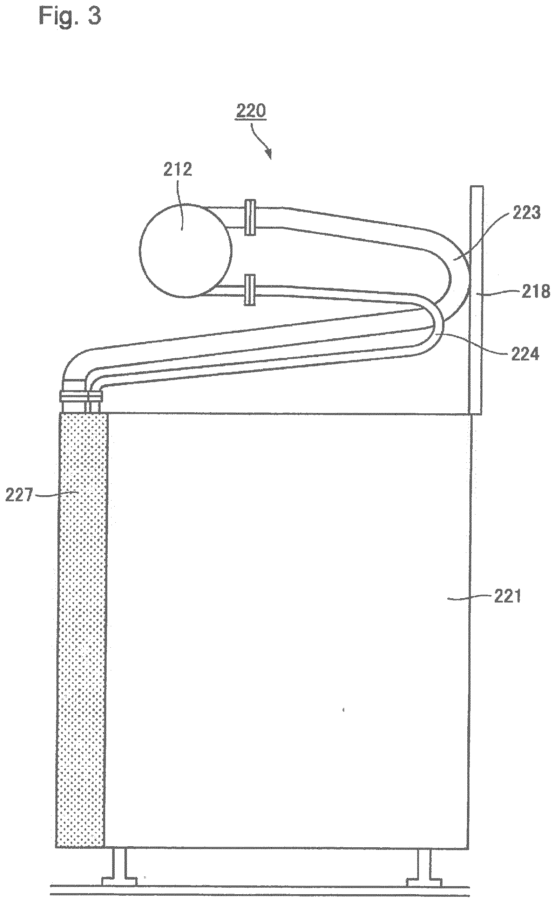

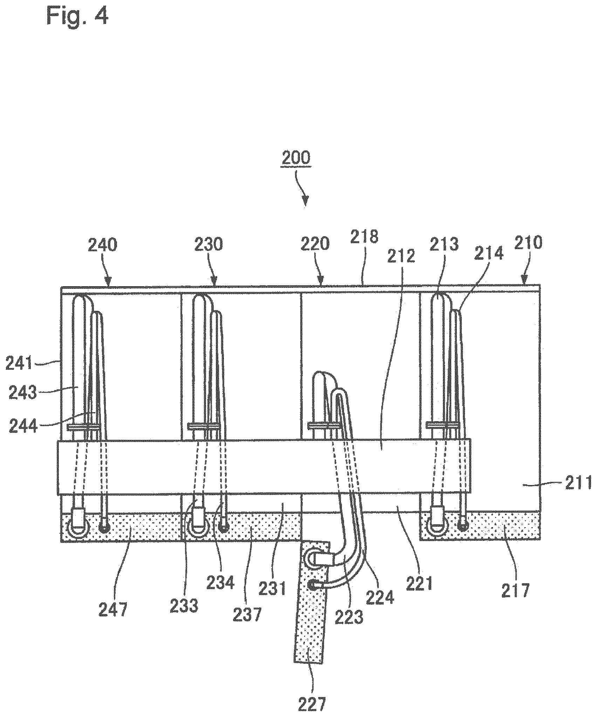

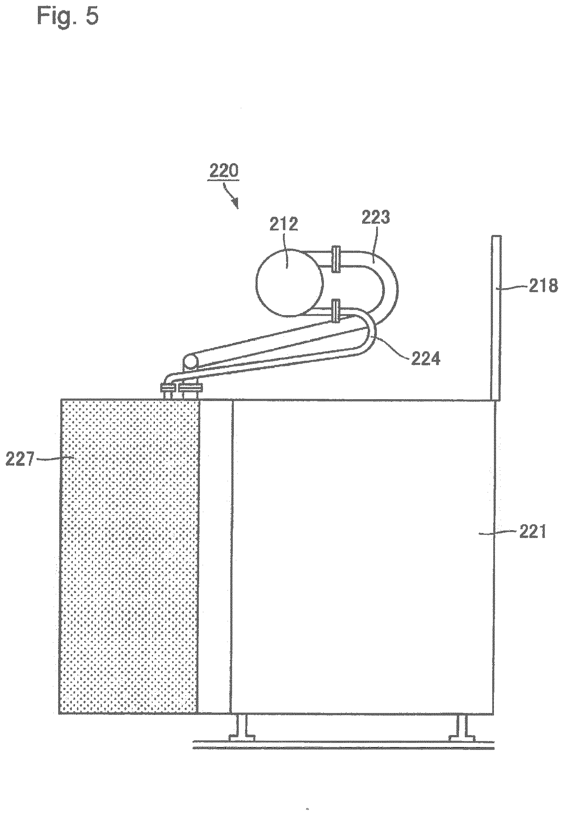

Another example embodiment (second example embodiment) of the present invention will be described using Figs. 2 to 5. Figs. 2 and 3 are a plan view and a side view of a cooling system 200 according to the present example embodiment (second example embodiment), respectively. Figs. 4 and 5 are a plan view and a side view of the cooling system 200 according to the present example embodiment (second example embodiment), respectively, and diagrams illustrating a state in which a rear-surface door of a casing 221 is opened.

The cooling system 200 is configured including a plurality of cooling devices 210, 220, 230, and 240. Note that, since the plurality of cooling devices 210, 220, 230, and 240 have the same configuration, the cooling device 220 will be described and a description of the other cooling devices 210, 230, and 240 will be omitted. The cooling device 220 is configured including an evaporating unit 227, a not-illustrated condensing unit, a refrigerant relay 212, a refrigerant vapor tube 223, and a refrigerant liquid tube 224.

The evaporating unit 227 of the cooling device 220 is disposed so as to cover the rear-surface side of the casing 221. In the present example embodiment, the casing 221 is made up of a top surface, a bottom surface, a front surface, a rear surface, and side surfaces and is formed constituting a rectangular parallelepiped shape. Note that, hereinafter, the surface illustrated in Fig. 2 is referred to as the top surface, and the upper side, the lower side, and the right and left sides in the Fig. 2 are referred to as the front surface, the rear surface, and the side surfaces, respectively. In addition, based on the above definition, the up and down direction, the right and left direction, and the depth direction in the Fig. 2 are referred to as a front-to-rear direction, a side-to-side direction, and a top-to-bottom direction, respectively.

The evaporating unit 227 functions as the rear-surface door of the casing 221 and is mounted on the casing 221 in a freely openable and closable manner by means of a not-illustrated metal fitting having a rotating shaft. In addition, the evaporating unit 227 is thermally connected to not-illustrated electronic devices contained inside the casing 221, and evaporation of refrigerant liquid stored inside the evaporating unit 227 takes heat away from the electronic devices. Note that, since the electronic devices are known technologies, a description thereof will be omitted. The evaporating unit 227 cools a heating element by, when taking heat away from the heating element, making the stored refrigerant liquid undergo a phase change to vapor (hereinafter, the vapor is referred to as refrigerant vapor). At this time, emitted heat from the heating element is absorbed by the refrigerant vapor. The refrigerant vapor flows into the refrigerant relay 212 via the refrigerant vapor tube. Further, the refrigerant vapor flows into a not-illustrated heat exchanger from the refrigerant relay 212.

The condensing unit is installed at a higher position than the evaporating unit 227. The condensing unit makes the refrigerant vapor undergo a phase change to liquid (hereinafter, the liquid is referred to as refrigerant liquid) and radiates heat. At this time, the condensing unit condenses and liquefies the refrigerant vapor by performing heat exchange with a low temperature medium, such as air.

The refrigerant vapor tube 223 serves as a flow path for flowing refrigerant vapor generated through a phase change in the evaporating unit 227 from the evaporating unit 227 to the refrigerant relay 212 by use of the buoyancy of the refrigerant vapor. In the present example embodiment, the refrigerant vapor tube 223 is configured using a freely bendable flexible tube made of metal. Note that, although, in the present example embodiment, the refrigerant vapor tube 223 is assumed to be made of metal, that is because the refrigerant vapor tube 223 made of resin, such as rubber and Teflon (Registered Trademark), causes air to permeate from the outside into the inside and lower the degree of vacuum, and, thus, the material constituting the refrigerant vapor tube 223 is not limited to a metal as long as satisfying the degree of vacuum described above. One end and the other end of the refrigerant vapor tube 223 are connected to the refrigerant relay 212 and the evaporating unit 227 on the casing 221, respectively. Note that, although the size of the refrigerant vapor tube 223 is not limited to a specific value, the size may, as an example, be set at an inner diameter of approximately 50 mm when, for example, heat of 15 kW is transported. As another example, the size may be set at an inner diameter of approximately 65mm when, for example, heat of 30kW is transported.

The refrigerant liquid tube 224 serves as a flow path for flowing refrigerant liquid generated through a phase change in the heat exchanger from the refrigerant relay 212 on the upstream side to the evaporating unit 227 on the downstream side by use of the gravity of the refrigerant liquid. The refrigerant liquid tube 224 is also configured using a freely bendable flexible tube as with the refrigerant vapor tube 223. One end and the other end of the refrigerant liquid tube 224 are also connected to the refrigerant relay 212 and the evaporating unit 227, respectively, as with the refrigerant vapor tube 223.

In the above configuration, the evaporating unit 227 functions as a rear-surface door that opens and closes by rotating around the rotating shaft, as described above. For this reason, as the rear-surface door opens and closes, the positions of the other ends of the refrigerant vapor tube 223 and the refrigerant liquid tube 224 are drawn in the rear-surface direction of the casing 221. Therefore, in the present example embodiment, allowing the refrigerant vapor tube 223 and the refrigerant liquid tube 224 to be bent and stretched using surplus length and flexibility that the refrigerant vapor tube 223 and the refrigerant liquid tube 224 have enables opening and closing of the rear-surface door. In consequence, it becomes possible to, while retaining the connection between the refrigerant relay 212 and the evaporating unit 227, open and close the evaporating unit 227 as a rear-surface door.

The refrigerant relay 212 has a cylindrical shape and is extended along the side-to-side direction of the casing 221. Note that, although, in the present example embodiment, the refrigerant relay 212 is formed into a cylindrical shape, the cross-sectional shape thereof is not limited to a circular shape and may be formed into, for example, a rectangular shape. In addition, the refrigerant relay 212 is, as described above, disposed in an area above the top surface of the casing 221. On the other hand, in the above-described related cooling system 900, in order to secure the surplus length of the flexible tube 923, the refrigerant relay 912 is disposed, instead of in an area above the space for installation of the casing 921, at a position outside the space for installation of the casing 921, as described above. For this reason, in the related cooling system 900, another casing cannot be installed in a space on the front-surface side of the casing 921, and, when a sufficient space for installation is not available, it is impossible to install a lot of casings. By contrast, in the present example embodiment, the refrigerant relay 212 is disposed within the space for installation of the casing 221. In the present example embodiment, this dispositional configuration enables a saving in space for installation to be achieved.

In the present example embodiment, the refrigerant relay 212 is placed at a position between substantially the middle and the rear-surface side in the front-to-rear direction of the casing 221. In addition, the refrigerant relay 212 is placed at a position distanced by a predetermined height from the top surface of the casing 221. This configuration enables the refrigerant vapor tube 223 and the refrigerant liquid tube 224 to be bent and disposed within an area in the space for installation of the casing 221. Note that, although the position at which the refrigerant relay 212 is disposed is not limited to a specific position as long as being located between substantially the middle and the rear-surface side in the front-to-rear direction of the casing 221, the refrigerant relay 212 may preferably be positioned at substantially the middle. This configuration enables a sense of oppression given to users by the refrigerant relay 212 to be suppressed.

On the casing 221, a capping 218 is disposed. Note that the capping 218 is a component for controlling air flow in air conditioning and a product for achieving an efficient air conditioning environment by partitioning passages around the respective casings using walls, roofs, and the like and physically separating intake air (low temperature) and exhaust air (high temperature) to/from electronic devices. The capping 218 is erected at the edge on the front-surface side of the casing 221. This configuration enables the capping 218 to partition an area above the top surface of the casing 221 from an area on the front-surface side of the casing 221 and reduce influence of air flow on refrigerant flowing through the refrigerant relay 212, the refrigerant vapor tube 223, and the refrigerant liquid tube 224.

On the other hand, in the related cooling system 900, the refrigerant relay 912 is disposed at a position outside an area equivalent to the space for installation of the casing 921. For this reason, disposition of a capping to the cooling system 900 causes a necessity to open a hole through which the refrigerant vapor tube 923 is inserted on the capping. By contrast, in the cooling system 200 of the present example embodiment, since the refrigerant vapor tube 223 is disposed within the space for installation of the casing 221, it is not necessary to open a hole in the capping 218 that allows the refrigerant vapor tube 223 to pass therethrough, which enables air flow to be shielded more securely.

As described above, even when a tube that cannot be twisted, like the refrigerant vapor tube 223 made of metal, is used, the present example embodiment enables opening and closing of the rear-surface door with the connection of the refrigerant vapor tube 223 to the rear-surface door retained. In addition, even when the refrigerant vapor tube 223 is provided with surplus length in order to enable opening and closing of the rear-surface door, it becomes possible to keep the refrigerant vapor tube 223 contained within the space for installation of the casing 221. In consequence, the present example embodiment enables an increase in space for installation to be suppressed and more casings to be installed in a data center.

### (Third Example Embodiment)

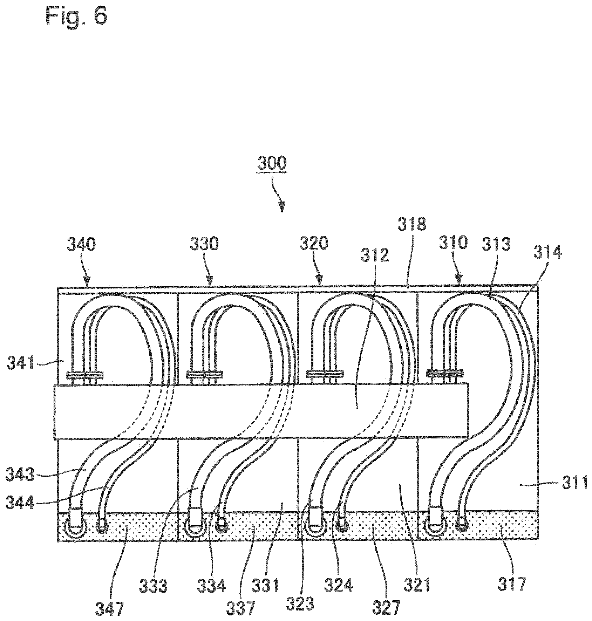

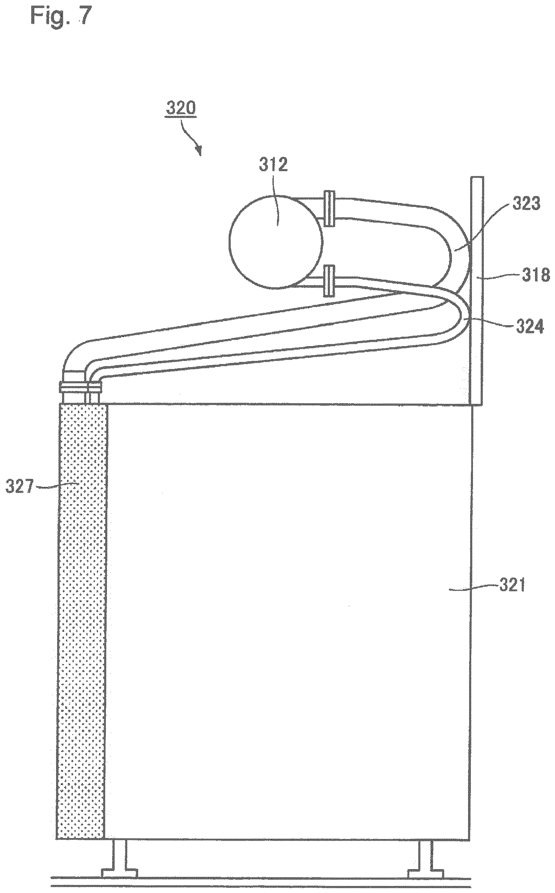

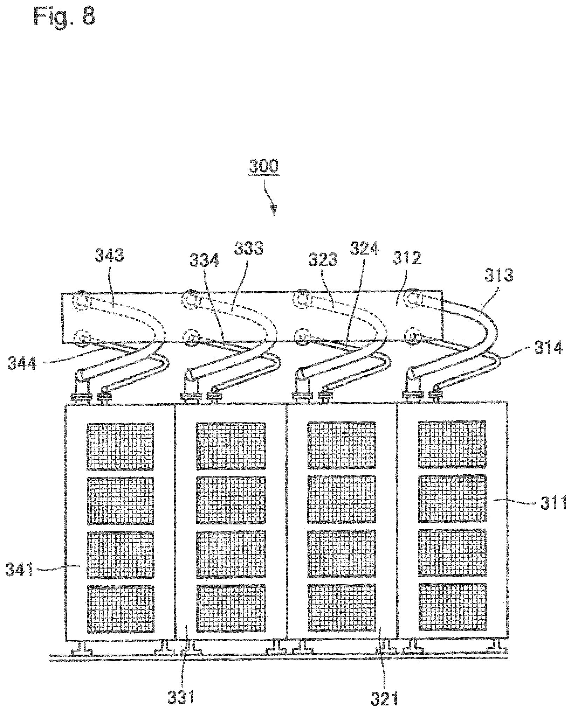

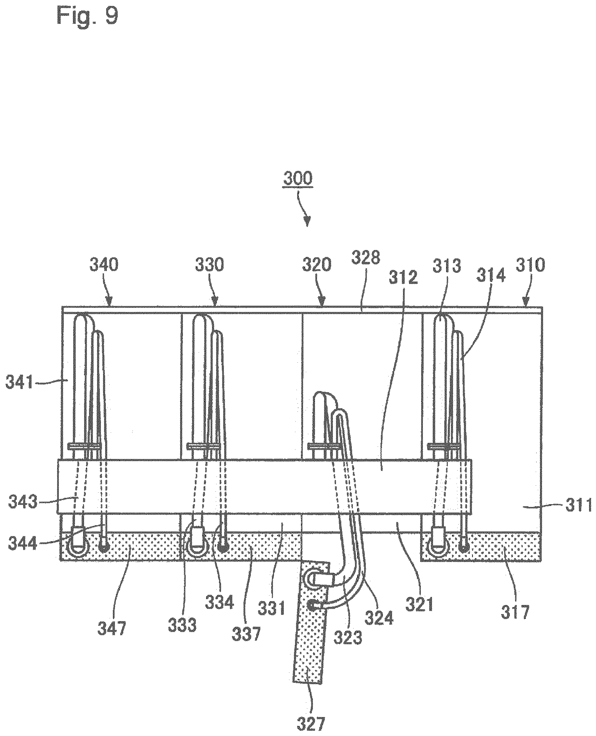

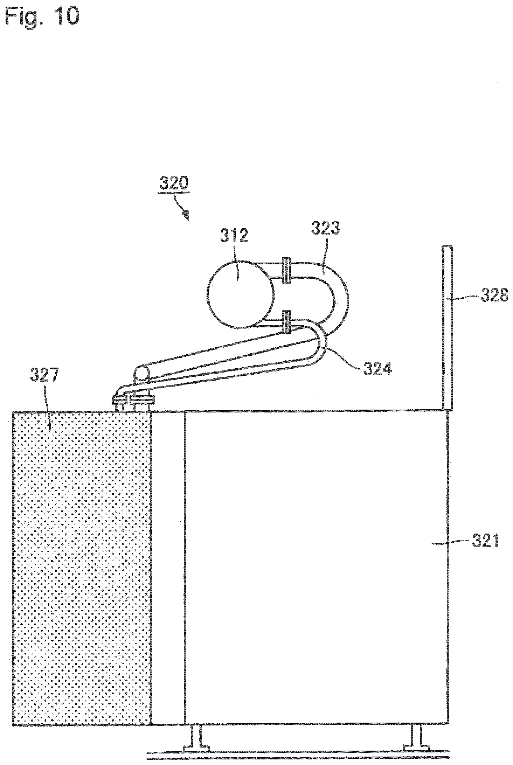

Still another example embodiment (third example embodiment) of the present invention will be described using Figs. 6 to 10. Figs. 6 to 8 are a plan view, a side view, and a rear view of a cooling device 300 according to the present example embodiment (third example embodiment), respectively. Figs. 9 and 10 are a plan view and a side view of the cooling system 300 according to the present example embodiment (third example embodiment), respectively, and diagrams illustrating a state in which a rear-surface door of a casing 321 is opened. Note that a cooling device 320 of the cooling system 300 of the present example embodiment is similar to the cooling device 220 of the second example embodiment described above except a difference in that a refrigerant vapor tube 323 and a refrigerant liquid tube 324 have a plurality of bend parts. Therefore, corresponding signs are assigned to the same components as those in the cooling device 220 of the second example embodiment described above and a description thereof will be omitted.

In the present example embodiment, the refrigerant vapor tube 323 and the refrigerant liquid tube 324 are disposed having a plurality of bend parts. In this configuration, refrigerant flowing through the refrigerant vapor tube 323 is a mixed two phase flow of vapor and liquid. The liquid ascends toward a refrigerant relay 312 dragged by the force of vapor flow. On this occasion, in the above-described second example embodiment, although the liquid flows along a lowest portion of the inner surface of the refrigerant vapor tube 223 until reaching a middle point, after the middle point, the inclination of the refrigerant vapor tube 223 turns to a reverse inclination, which causes the liquid flow to switch flow paths. For this reason, in the above-described second example embodiment, there is a possibility that the liquid flow switching phenomenon causes a vibration of the refrigerant vapor tube 223 to occur and the life of the refrigerant vapor tube 223 to be shortened. In addition, in the above-described second example embodiment, there is also a possibility that crossing of the liquid and the vapor at a position where the liquid flow switches flow paths causes the vapor flow to be hindered and a reduction in performance to be induced. By contrast, since, as described above, the refrigerant vapor tube 323 of the present example embodiment has a plurality of bend parts and a portion ascending to the refrigerant relay 312 is formed to obliquely ascend, there is no turn to a reverse inclination and the liquid continuously ascends along lowest portions in cross sections of the refrigerant vapor tube 323. For this reason, the present example embodiment neither hinders the flow of vapor nor causes a vibration of the refrigerant vapor tube 323 to occur, which enables the life of the refrigerant vapor tube 323 to be prevented from deteriorating.

As described above, the present example embodiment also enables opening and closing of the rear-surface door with the connection of the refrigerant vapor tube 323 to the rear-surface door retained. In addition, even when the refrigerant vapor tube 323 is provided with surplus length in order to enable opening and closing of the rear-surface door, it becomes possible to keep the refrigerant vapor tube 323 contained within the space for installation of the casing 321. In consequence, the present example embodiment enables an increase in space for installation to be suppressed and more casings to be installed in a data center.

Further, since, as described above, a portion of the refrigerant vapor tube 323 ascending to the refrigerant relay 312 is formed to obliquely ascend, the present example embodiment neither hinders the flow of vapor nor causes a vibration of the refrigerant vapor tube 323 to occur, which enables the life of the refrigerant vapor tube 323 to be prevented from deteriorating.

The present invention was described above through example embodiments (and examples) thereof, but the present invention is not limited to the above example embodiments (and examples). Various modifications that could be understood by a person skilled in the art may be applied to the configurations and details of the present invention within the scope of appended claims.

### [Reference signs List]

- 100: Cooling system
- 112: Coolant relay
- 120: Cooling device
- 121: Casing
- 123: Flexible tube
- 127: Evaporator

## Claims

1. A cooling device, comprising:
a casing (121; 221; 321) on which a rear-surface door that is mounted in an openable and closable manner;
an evaporator (127; 227; 327) that is disposed on the rear-surface door;
a refrigerant relay (112; 212; 312) that is placed above the casing with respect to a vertical direction and connected to a condenser, the position of the refrigerant relay being static relative to the casing; and
a freely bendable flexible tube (123; 223, 224; 323; 324) having i) one end that is connected to the evaporator on a first side with respect to the refrigerant relay on which the evaporator is disposed, and ii) the other end that is connected to the refrigerant relay on a second side with respect to the refrigerant relay, the second side being opposite, in a plan view of the cooling device, to the first side, wherein
the refrigerant relay is disposed above the one end of the flexible tube,
the flexible tube extends in a first direction perpendicular to the vertical direction at the other end of the flexible tube,
the flexible tube has a surplus tube length which enables the opening and closing of the rear-surface door, and
at least a portion of the flexible tube is disposed below the refrigerant relay so as to cross the refrigerant relay in a grade-separated manner by making the flexible tube, after passing below the refrigerant relay from the first side on which the evaporator is disposed, reverse its extending direction and be connected to the refrigerant relay.

2. The cooling device according to claim 1, wherein the refrigerant relay (312) is positioned at substantially a middle above the casing (321).

3. The cooling device according to claim 1 or 2, wherein the flexible tube (123; 223, 224; 323; 324) has a bend part at the second side.

4. The cooling device according to claim 1 or 2, wherein the flexible tube (323, 324) is disposed having a plurality of bend parts.

5. The cooling device according to any one of claims 1 to 4, wherein at least a portion of the flexible tube (123; 223, 224; 323; 324) is formed to extend obliquely upward from a region of the flexible tube positioned below the refrigerant relay toward the refrigerant relay (112; 212; 312).

6. The cooling device according to any one of claims 1 to 5, wherein the second side is positioned on a front-surface side of the casing (121; 221; 321).

7. The cooling device according to any one of claims 1 to 6, wherein
the refrigerant relay (112; 212; 312) extends in a second direction that is perpendicular to the vertical direction and the first direction,
the cooling device comprising:
a plurality of the casings (121; 221; 321) arranged next each other along the second direction;
a plurality of the evaporators (127; 227; 327) that are disposed on the rear-surface door of the corresponding casings; and
a plurality of the flexible tubes (123; 223, 224; 323; 324) by each of which each of the plurality of the evaporators is connected to the refrigerant relay.

8. The cooling device according to claim 7, wherein the flexible tube is a plurality of flexible tubes,
each of the flexible tubes includes a refrigerant vapor tube (223; 323) serving as a flow path for flowing refrigerant vapor generated through a phase change in the evaporator (227; 327) from the evaporator (227; 327) to the refrigerant relay (212; 312), and a refrigerant liquid tube (224; 324) serving as a flow path for flowing refrigerant liquid generated through a phase change in the condenser from the refrigerant relay (212; 312), and
the refrigerant vapor tube (223; 323) is connected horizontally at its other end to the refrigerant relay (212; 312) above a centerline of the refrigerant relay (212; 312),
and the refrigerant liquid tube (224,324) is connected horizontally at its other end to the refrigerant relay (212; 312) below the centerline of the refrigerant relay (212,312).

## Patentansprüche

1. Kühlvorrichtung, umfassend:
ein Gehäuse (121; 221; 321), an welchem eine rückseitige Tür auf öffnungs- und schließbare Weise angebracht ist;
ein Verdampfer (127; 227; 327), der an der rückseitigen Tür angeordnet ist;
ein Kühlmittelrelais (112; 212; 312), das in Bezug auf eine vertikale Richtung über dem Gehäuse platziert und mit einem Dampfkondensator verbunden ist, wobei die Position des Kühlmittelrelais relativ zum Gehäuse statisch ist; und
ein frei biegbares flexibles Rohr (123; 223, 224; 323; 324) mit i) einem Ende, das auf einer ersten Seite in Bezug auf das Kühlmittelrelais, auf welcher der Verdampfer angeordnet ist, mit dem Verdampfer verbunden ist, und ii) dem anderen Ende, das auf einer zweiten Seite in Bezug auf das Kühlmittelrelais mit dem Kühlmittelrelais verbunden ist, wobei die zweite Seite in einer Draufsicht auf die Kühlvorrichtung gegenüberliegend zur ersten Seite ist, wobei
das Kühlmittelrelais über dem einen Ende des flexiblen Rohrs angeordnet ist,
das flexible Rohr sich in einer ersten Richtung senkrecht zur vertikalen Richtung am anderen Ende des flexiblen Rohrs erstreckt,
das flexible Rohr eine überschüssige Rohrlänge hat, die das Öffnen und Schließen der rückseitigen Tür ermöglicht, und
wenigstens ein Teilbereich des flexiblen Rohrs unter dem Kühlmittelrelais angeordnet ist, um das Kühlmittelrelais auf planfreie Weise zu kreuzen, indem veranlasst ist, dass das flexible Rohr nach einem Vorbeigehen unter dem Kühlmittelrelais von der ersten Seite aus, auf welcher der Verdampfer angeordnet ist, seine Erstreckungsrichtung umkehrt und mit dem Kühlmittelrelais verbunden ist.

2. Kühlvorrichtung nach Anspruch 1, wobei das Kühlmittelrelais (312) bei im Wesentlichen einer Mitte über dem Gehäuse (321) positioniert ist.

3. Kühlvorrichtung nach Anspruch 1 oder 2, wobei das flexible Rohr (123; 223, 224; 323; 324) einen Biegeteil auf der zweiten Seite hat.

4. Kühlvorrichtung nach Anspruch 1 oder 2, wobei das flexible Rohr (323, 324) mit einer Vielzahl von Biegeteilen angeordnet ist.

5. Kühlvorrichtung nach einem der Ansprüche 1 bis 4, wobei wenigstens ein Teilbereich des flexiblen Rohrs (123; 223, 224; 323; 324) ausgebildet ist, um sich von einem Bereich des flexiblen Rohrs aus, der unter dem Kühlmittelrelais in Richtung zum Kühlmittelrelais (112; 212; 312) positioniert ist, schräg nach oben zu erstrecken.

6. Kühlvorrichtung nach einem der Ansprüche 1 bis 5, wobei die zweite Seite auf einer Vorderseite des Gehäuses (121; 221; 321) positioniert ist.

7. Kühlvorrichtung nach einem der Ansprüche 1 bis 6, wobei
sich das Kühlmittelrelais (112; 212; 312) in einer zweiten Richtung erstreckt, die senkrecht zu der vertikalen Richtung und der ersten Richtung ist,
wobei die Kühlvorrichtung folgendes umfasst:
eine Vielzahl der Gehäuse (121; 221; 321), die entlang der zweiten Richtung nebeneinander angeordnet sind;
eine Vielzahl der Verdampfer (127; 227; 327), die an der rückseitigen Tür der entsprechenden Gehäuse angeordnet sind; und
eine Vielzahl der flexiblen Rohre (123; 223, 224; 323; 324), durch jedes von welchen jeder der Vielzahl der Verdampfer mit dem Kühlmittelrelais verbunden ist.

8. Kühlvorrichtung nach Anspruch 7, wobei
das flexible Rohr eine Vielzahl von flexiblen Rohren ist,
jedes der flexiblen Rohre ein Kühlmitteldampfrohr (223; 323) enthält, das als Durchflussweg für durch einen Phasenwechsel im Verdampfer (227; 327) erzeugten fließenden Kühlmitteldampf vom Verdampfer (227; 327) zum Kühlmittelrelais (212; 312) dient, und ein Kühlmittelflüssigkeitsrohr (224; 324), das als Durchflussweg für durch einen Phasenwechsel im Dampfkondensator erzeugte fließende Kühlmittelflüssigkeit vom Kühlmittelrelais (212; 312) dient, und
das Kühlmitteldampfrohr (223; 323) an seinem anderen Ende über einer Mittenlinie des Kühlmittelrelais (212; 312) mit dem Kühlmittelrelais (212; 312) horizontal verbunden ist,
und das Kühlmittelflüssigkeitsrohr (224, 324) an seinem anderen Ende unter der Mittenlinie des Kühlmittelrelais (212; 312) mit dem Kühlmittelrelais (212; 312) horizontal verbunden ist.

## Revendications

1. Dispositif de refroidissement, comprenant :
un boîtier (121; 221; 321) sur lequel une porte de surface arrière est montée de manière à pouvoir être ouverte et fermée ;
un évaporateur (127 ; 227 ; 327) qui est disposé sur la porte de surface arrière ;
un relais de réfrigérant (112; 212; 312) qui est placé au-dessus du boîtier par rapport à une direction verticale et relié à un condensateur, la position du relais de réfrigérant étant statique par rapport au boîtier ; et
un tube souple librement pliable (123; 223, 224; 323; 324) ayant i) une extrémité qui est reliée à l'évaporateur sur un premier côté par rapport au relais de réfrigérant sur lequel l'évaporateur est disposé, et ii) l'autre extrémité qui est reliée au relais de réfrigérant sur un deuxième côté par rapport au relais de réfrigérant, le deuxième côté étant à l'opposé, dans une vue en plan du dispositif de refroidissement, du premier côté, dans lequel
le relais de réfrigérant est disposé au-dessus de l'une extrémité du tube souple,
le tube souple s'étend dans une première direction perpendiculaire à la direction verticale à l'autre extrémité du tube souple,
le tube souple a une longueur de tube supplémentaire qui permet l'ouverture et la fermeture de la porte de surface arrière, et
au moins une portion du tube souple est disposée au-dessous du relais de réfrigérant de manière à croiser le relais de réfrigérant en dénivelé en amenant le tube souple à, après être passée au-dessous du relais de réfrigérant depuis le premier côté sur lequel l'évaporateur est disposé, inverser sa direction d'extension et être relié au relais de réfrigérant.

2. Dispositif de refroidissement selon la revendication 1, dans lequel le relais de réfrigérant (312) est positionné sensiblement à un milieu au-dessus du boîtier (321).

3. Dispositif de refroidissement selon la revendication 1 ou 2, dans lequel le tube souple (123 ; 223, 224 ; 323 ; 324) a une partie de courbure au deuxième côté.

4. Dispositif de refroidissement selon la revendication 1 ou 2, dans lequel le tube souple (323, 324) est disposé en ayant une pluralité de parties de courbure.

5. Dispositif de refroidissement selon l'une quelconque des revendications 1 à 4, dans lequel au moins une portion du tube souple (123 ; 223, 224 ; 323 ; 324) est formée pour s'étendre obliquement vers le haut depuis une région du tube souple positionnée au-dessous du relais de réfrigérant vers le relais de réfrigérant (112 ; 212; 312).

6. Dispositif de refroidissement selon l'une quelconque des revendications 1 à 5, dans lequel le deuxième côté est positionné sur un côté de surface avant du boîtier (121 ; 221; 321).

7. Dispositif de refroidissement selon l'une quelconque des revendications 1 à 6, dans lequel
le relais de réfrigérant (112; 212; 312) s'étend dans une deuxième direction qui est perpendiculaire à la direction verticale et à la première direction,
le dispositif de refroidissement comprenant :
une pluralité des boîtiers (121 ; 221; 321) agencés l'un à côté de l'autre le long de la deuxième direction ;
une pluralité des évaporateurs (127 ; 227 ; 327) qui sont disposés sur la porte de surface arrière des boîtiers correspondants ; et
une pluralité des tubes souples (123 ; 223, 224 ; 323 ; 324) par lesquels chacun de la pluralité des évaporateurs est relié au relais de réfrigérant.

8. Dispositif de refroidissement selon la revendication 7, dans lequel le tube souple est une pluralité de tubes souples,
chacun des tubes souples comprend un tube de vapeur de réfrigérant (223 ; 323) servant de voie d'écoulement pour l'écoulement de vapeur de réfrigérant générée par l'intermédiaire d'un changement de phase dans l'évaporateur (227 ; 327) depuis l'évaporateur (227 ; 327) jusqu'au relais de réfrigérant (212 ; 312), et un tube de liquide de réfrigérant (224; 324) servant de voie d'écoulement pour l'écoulement de liquide de réfrigérant généré par l'intermédiaire d'un changement de phase dans le condensateur depuis le relais de réfrigérant (212 ; 312), et
le tube de vapeur de réfrigérant (223 ; 323) est relié horizontalement à son autre extrémité au relais de réfrigérant (212 ; 312) au-dessus d'une ligne médiane du relais de réfrigérant (212 ; 312), et le tube de liquide de réfrigérant (224 ; 324) est relié horizontalement à son autre extrémité au relais de réfrigérant (212 ; 312) au-dessous de la ligne médiane du relais de réfrigérant (212, 312).
